(19) Europäisches Patentamt

European Patent Office

Office européen des brevets

(11) **EP 1 035 587 A1**

(12) **EUROPEAN PATENT APPLICATION**
published in accordance with Art. 158(3) EPC

(43) Date of publication:
**13.09.2000 Bulletin 2000/37**

(51) Int. Cl.[7]: **H01L 27/10**, H01L 21/8239,
H01L 21/318, H01L 21/822,
H01L 27/04

(21) Application number: **98938941.6**

(22) Date of filing: **21.08.1998**

(86) International application number:
**PCT/JP98/03724**

(87) International publication number:
**WO 99/12210 (11.03.1999 Gazette 1999/10)**

(84) Designated Contracting States:
**DE FR GB IT NL**

(30) Priority: **28.08.1997 JP 23203597**
**28.08.1997 JP 23209297**

(71) Applicant: **Rohm Co., Ltd.**
**Kyoto-shi Kyoto 615-8585 (JP)**

(72) Inventors:
• **SAMESHIMA, Katsumi**
**Kyoto-shi Kyoto 615-8585 (JP)**
• **OZAWA, Takanori**
**Rohm Co., Ltd.**
**Kyoto-shi Kyoto 615-8585 (JP)**

• **FUCHIKAMI, Takaaki**
**Rohm Co., Ltd.**
**Kyoto-shi Kyoto 615-8585 (JP)**
• **HOSHIBA, Kazuhiro**
**Rohm Co., Ltd.**
**Kyoto-shi Kyoto 615-8585 (JP)**
• **NAKAO, Yuichi**
**Rohm Co., Ltd.**
**Kyoto-shi Kyoto 615-8585 (JP)**

(74) Representative:
**Barth, Stephan Manuel**
**Reinhard-Skuhra-Weise & Partner Gbr,**
**Patentanwälte**
**Friedrichstrasse 31**
**80801 München (DE)**

(54) **SEMICONDUCTOR DEVICE AND METHOD OF PRODUCING THE SAME**

(57)    A semiconductor device and a process of fabricating same are provided, in which the hysteresis characteristic of a ferroelectric material is not easily deteriorated and which has high reliability under high humidity conditions. A passivation film 42 of a dense silicon nitride film is formed to cover a ferroelectric capacitor Cf, so that intrusion of moisture from outside can be prevented. The volume percentage of $SiH_4$ and $NH_3$, which are hydrogen-containing gases contained in a film forming gas for the passivation film 42, is set to a low level. Also, adjustment is made so as to reduce a hydrogen concentration in the passivation film 42. Further, an upper electrode 36 for the ferroelectric capacitor Cf has a two-layered structure in which $IrO_2$ and Ir are stacked in this order. By this expedience, the amount of hydrogen generated during the film forming process and the amount of hydrogen in the passivation film 42 after the film formation thereof are small. Moreover, it is possible to prevent, in a certain degree, hydrogen from arriving at a ferroelectric layer 34. Namely, deterioration of hysteresis characteristic of the ferroelectric capacitor Cf material due to hydrogen can be prevented.

Fig.1

38: INTERLAYER FILM
40: ALUMINUM WIRE
42: PASSIVATION FILM
Cf: FERROELECTRIC CAPACITOR

## Description

### Reference to Related Applications

The entire teachings of Japanese Patent Application No. H9-232035 (filed August 28, 1997) and Japanese Patent Application No. H9-232092 (filed August 28, 1997), inclusive of their specifications, claims, drawings and abstracts, are hereby incorporated by reference herein.

### Technical Field

This invention relates to a semiconductor device and a process of fabricating same and, particularly, to a semiconductor device having a ferroelectric layer.

### Background Art

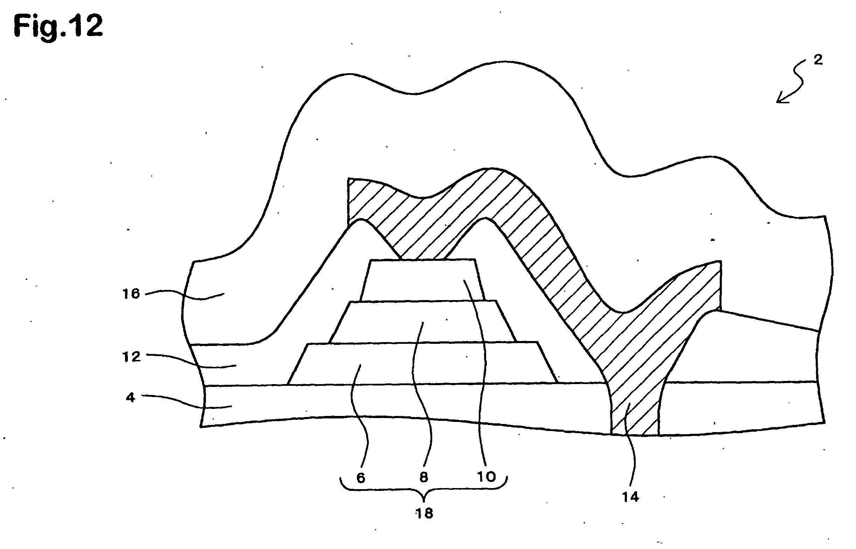

A ferroelectric memory is known which utilizes hysteresis characteristic of its ferroelectric material in polarization charges thereof relative to a voltage impressed to thereto. Fig. 12 is a sectional view illustrating constitution of an example of a conventional ferroelectric memory.

The conventional ferroelectric memory 2 has a ferroelectric capacitor 18 provided on an interlayer film 4 and composed of a lower electrode 6 made of Pt (platinum), a ferroelectric layer 8 made of a ferroelectric material such as PZT (PbZr$_x$Ti$_{1-x}$O$_3$) and an upper electrode 10 made of Pt (platinum), which are stacked in this order. An interlayer film 12 is formed to cover the ferroelectric capacitor 18. Designated as 14 is an aluminum wire. A passivation film 16 is formed to protect these elements.

The conventional ferroelectric memory 2, however, has the following problems. The ferroelectric material tends to be deteriorated by hydrogen. Namely, by the action of hydrogen on the ferroelectric material, the hysteresis characteristics thereof are deteriorated. Since the electrode, especially the upper electrode 10 of the conventional ferroelectric memory 2 is made of Pt, it is difficult to prevent the intrusion of hydrogen into the ferroelectric layer 8 during a process of forming the passivation film and the intrusion of hydrogen from the passivation film into the ferroelectric layer 8 after the formation of the passivation film.

To cope with this problem, a process has been proposed in which the passivation film 16 is formed by a silicon oxide film using TEOS (tetraethyl orthosilicate which is a kind of organosilicon source) with which the influence of hydrogen upon the ferroelectric layer 8 is relatively small.

However, a silicon oxide film (SiO$_2$) is poor in moisture-proof property and easily permits both penetration of moisture therethrough and retention of moisture therein. Therefore, the ferroelectric memory 2 has not high reliability under high humidity conditions.

### Disclosure of the Invention

The present invention is aimed at the provision of a semiconductor device in which the foregoing problems have been solved, in which the hysteresis characteristic of a ferroelectric material is not easily deteriorated and which has high reliability under high humidity conditions, and of a process of fabricating same.

A semiconductor device in accordance with the present invention comprises a ferroelectric layer, an electrically conductive layer in contact with said ferroelectric layer and an insulation layer disposed near said ferroelectric layer, and is characterized

in that said insulation layer is formed of an insulating material comprising silicon nitride, and
in that said conductive layer is formed of an electrically conductive material comprising a conductive oxide.

A process of fabricating a semiconductor device in accordance with the present invention comprising a ferroelectric layer, an electrically conductive layer in contact with said ferroelectric layer and an insulation layer disposed near said ferroelectric layer, is characterized

in that said ferroelectric layer is formed using a ferroelectric material and said electrically conductive layer is formed using an electrically conductive material comprising a conductive oxide, and
in that said insulation layer is thereafter formed using a film forming gas containing silane and ammonia and is formed of an insulating material comprising silicon nitride.

A semiconductor device according to the present invention comprises a ferroelectric layer and an insulation layer disposed near said ferroelectric layer, and is characterized

in that said insulation layer is formed of an insulation material containing silicon nitride having silicon-hydrogen bonds, and
in that the concentration of the hydrogen constituting said silicon-hydrogen bonds is such that the number of the hydrogen atoms is substantially not greater than $1.0 \times 10^{22}/cm^3$.

A semiconductor device according to the present invention comprises a ferroelectric layer and an insulation layer disposed near said ferroelectric layer, and is characterized

in that said insulation layer is formed of an insulation material containing silicon nitride having silicon-hydrogen bonds and nitrogen-hydrogen bonds, and

in that the concentration of the hydrogen constituting said silicon-hydrogen bonds and nitrogen-hydrogen bonds is such that the number of the hydrogen atoms is substantially not greater than $1.6 \times 10^{22}/cm^3$.

A semiconductor device according to the present invention comprises a ferroelectric layer and an insulation layer disposed near said ferroelectric layer, and is characterized

in that said insulation layer is formed of an insulation material containing silicon nitride, and
in that the concentration of hydrogen contained in said insulation layer is so adjusted that a switching capacitance of said ferroelectric layer after said insulation layer has been formed is reduced by no more than 25 % of a switching capacitance of said ferroelectric layer before the formation of said insulation layer.

A process of fabricating a semiconductor device according to the present invention comprising a ferroelectric layer, and an insulation layer disposed near said ferroelectric layer, is characterized

in that, after the formation of said ferroelectric capacitor, said insulation layer is formed using a film forming gas containing silane and ammonia such that said insulation layer is formed of an insulating material comprising silicon nitride, and
in that a volume of said silane and ammonia in said film forming gas is substantially not greater than 70 %.

The features of the present invention can be broadly illustrated as described above. However, the constitution and content of the present invention as well as further objects and features thereof will become apparent from the following disclosure when considered in light of the accompanying drawings.

## Brief Description of the Drawings

Fig. 1 is a sectional view illustrating a part (a vicinity of ferroelectric capacitor Cf) of the constitution of a ferroelectric memory M having a 2-transistor/2-capacitor structure and being a semiconductor device of one embodiment according to the present invention.
Fig. 2A is a sectional view explanatory of a step of the fabrication of a ferroelectric memory M.
Fig. 2B is a sectional view explanatory of a step of the fabrication of a ferroelectric memory M.
Fig. 3A is a sectional, view explanatory of a step of the fabrication of a ferroelectric memory M.
Fig. 3B is a sectional view explanatory of a step of the fabrication of a ferroelectric memory M.
Fig. 4A is a sectional view explanatory of a step of the fabrication of a ferroelectric memory M.
Fig. 4B is a sectional view explanatory of a step of the fabrication of a ferroelectric memory M.
Fig. 5 is an illustration of a volume percentage of $SiH_4$ and $NH_3$ in a film forming gas of each passivation film 42.
Fig. 6 is an illustration of a hydrogen concentration of Si-H bonds contained in each passivation film 42.
Fig. 7 is an illustration of a total hydrogen concentration of Si-H bonds and N-H bonds contained in each passivation film 42.
Fig. 8 is an illustration of a reduction percentage in switching capacitance Qsw of a ferroelectric capacitor Cf after formation of each passivation film 42.
Fig. 9 is an illustration of a constitution of a Sawyer-Tower circuit.
Fig. 10 is an illustration of a hysteresis curve of a ferroelectric material as measured with the Sawyer-Tower circuit.
Fig. 11 is an illustration of a constitution of a ferroelectric memory M having a 2-transistor/2-capacitor structure.
Fig. 12 is a sectional view illustrating an example of constitution of a conventional ferroelectric memory 2.

## Best Mode for Carrying out the Invention

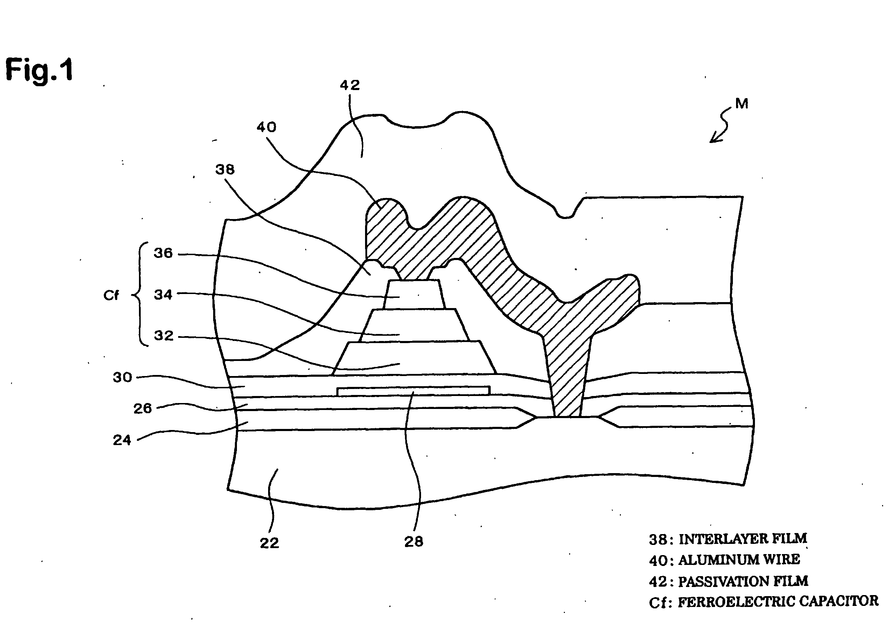

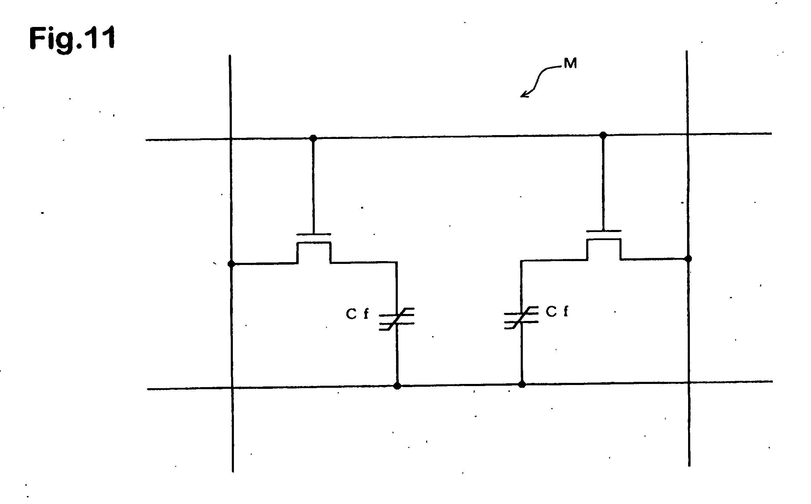

Fig. 11 shows an example of a circuit constitution of a ferroelectric memory M having a 2-transistor/2-capacitor structure and being a semiconductor device of one embodiment according to the present invention. Fig. 1 is a sectional view illustrating a part (a vicinity of ferroelectric capacitor Cf) of the constitution of a ferroelectric memory M. As shown in Fig. 1, the ferroelectric memory M has a silicon substrate 22 on which a field oxide film 24, an interlayer film 26, a gate 28 and an interlayer film 30 are arranged, with the ferroelectric capacitor Cf being further provided thereon.
The ferroelectric capacitor Cf has a constitution in which a lower electrode 32 representing a lower conductive layer, a ferroelectric layer 34 made of a ferroelectric material such as PZT ($PbZr_xTi_{1-x}O_3$) and an upper electrode 36 representing an upper conductive layer are stacked in this order. The lower electrode 32 has a two-layered structure in which $IrO_2$ (iridium oxide) and Pt (platinum) are stacked in this order. The upper electrode 36 representing a conductive layer has a two-layered structure in which a first layer of $IrO_2$ (iridium oxide) and a second layer of Ir (iridium) are stacked in this order.
An interlayer film 38 is provided to cover the ferroelectric capacitor Cf. Designated as 40 is an aluminum wire. A passivation film 42 representing a surface protecting film is provided to protect the above elements. Each of the interlayer films 26, 30 and 38 is constituted of a silicon oxide film. The passivation film 42 being an insulation layer is constituted of a silicon nitride film having a low hydrogen concentration.

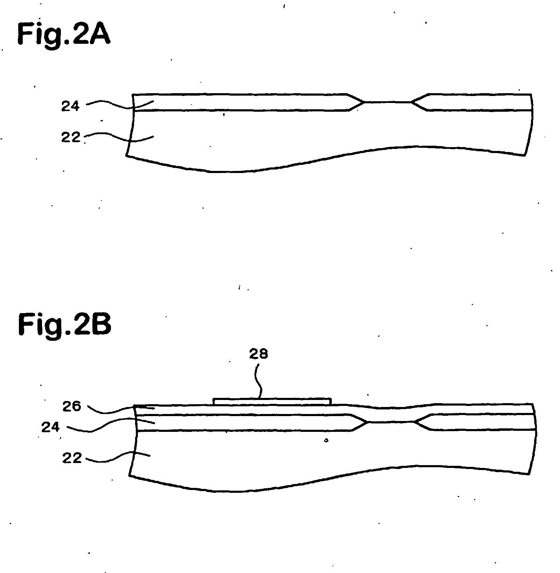

A method of fabricating the ferroelectric memory M will be next described with reference to Figs. 2A through 4B and Fig. 1. As shown in Fig. 2A, a silicon substrate is first provided. A field oxide film 24 is then formed on a part of the silicon substrate 22 by, for example, LOCOS (Local Oxidation of Silicon) method.

As shown in Fig. 2B, an interlayer film 26 is next formed. A gate 28 is formed on the interlayer film 26. The interlayer film 26 is formed by deposition of silicon oxide by, for example, CVD (Chemical Vapor Deposition) method. The gate 28 is formed by deposition of polysilicon by, for example, CVD method, followed by patterning into a predetermined shape by, for example, RIE (Reactive Ion Etching).

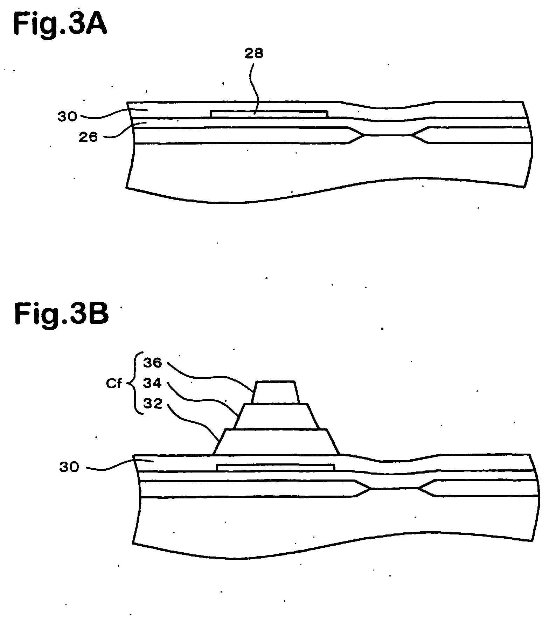

Subsequently, as shown in Fig. 3A, an interlayer film 30 is formed by deposition of silicon oxide by, for example, CVD method.

As shown in Fig. 3B, a ferroelectric capacitor Cf is then formed on the interlayer film 30 in the following manner. First, a layer serving as a lower electrode 32 is formed on the interlayer film 30 by, for example, sputtering. The layer serving as the lower electrode 32 has a two-layered structure obtained by stacking $IrO_2$ (iridium oxide) and Pt (platinum) in this order. Next, a layer serving as a ferroelectric layer 34 is formed by, for example, Sol-Gel method. The layer serving as the ferroelectric layer 34 is formed of PZT ($PbZr_xTi_{1-x}O_3$). Further, a layer serving as an upper electrode 36 is formed by, for example, sputtering. The layer serving as the upper electrode 36 has a two-layered structure obtained by stacking $IrO_2$ (iridium oxide) and Ir (iridium) in this order. The thus formed three layers are subjected to patterning by etching, thereby forming the ferroelectric capacitor Cf.

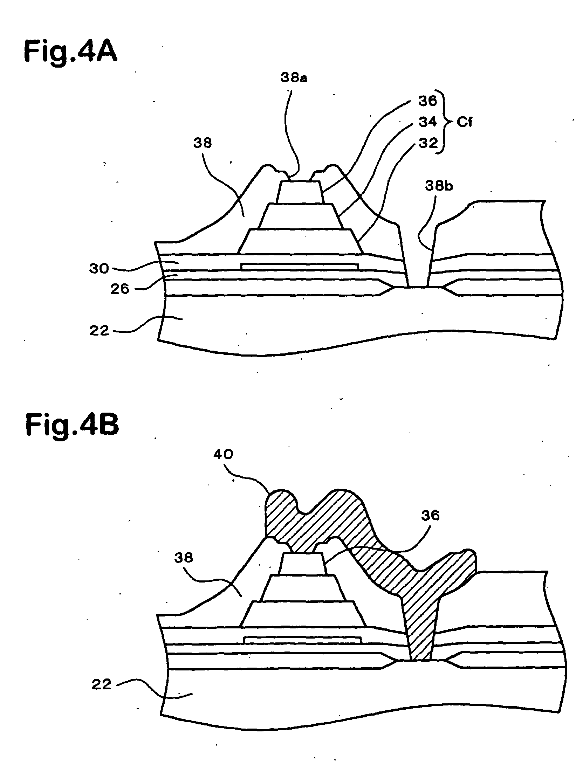

Thereafter, as shown in Fig. 4A, an interlayer film 38 is formed by deposition of a silicon oxide film by, for example, plasma CVD method using TEOS (tetraethyl orthosilicate) as an organic silicon source. Then, contact holes 38a and 38b are formed by etching in the thus obtained interlayer film 38. The contact hole 38a is formed so as to arrive at an upper surface of the upper electrode 36 of the ferroelectric capacitor Cf, while the contact hole 38b is formed so as to extend to the silicon substrate 22.

As shown in Fig. 4B, an aluminum wire 40 is formed by preparing a layer providing the aluminum wire 40 by, for example, sputtering, followed by patterning into a predetermined shape by etching.

Finally, as shown in Fig. 1, a passivation film 42 is formed by deposition of a silicon nitride film (SiN) having a low hydrogen content by plasma CVD method.

$SiH_4$ (silane), $NH_3$ (ammonia), nitrogen ($N_2$) and nitrogen oxide ($N_2O$) are used for film forming gaseous elements for the passivation film 42.

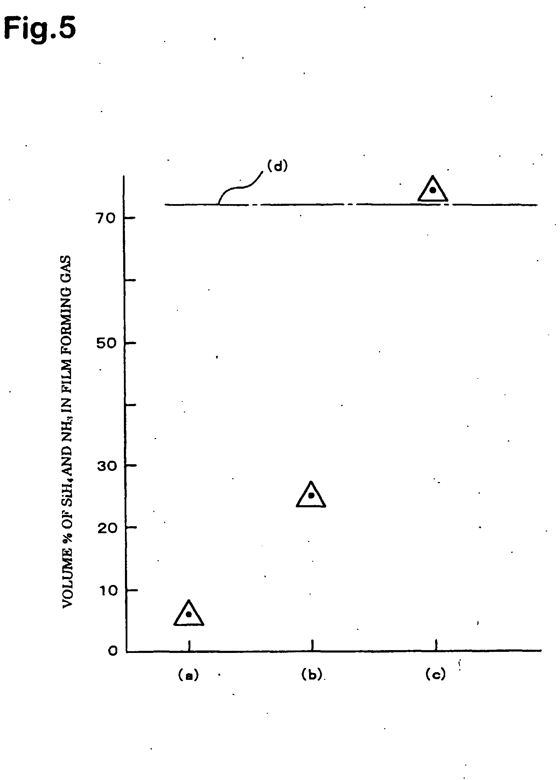

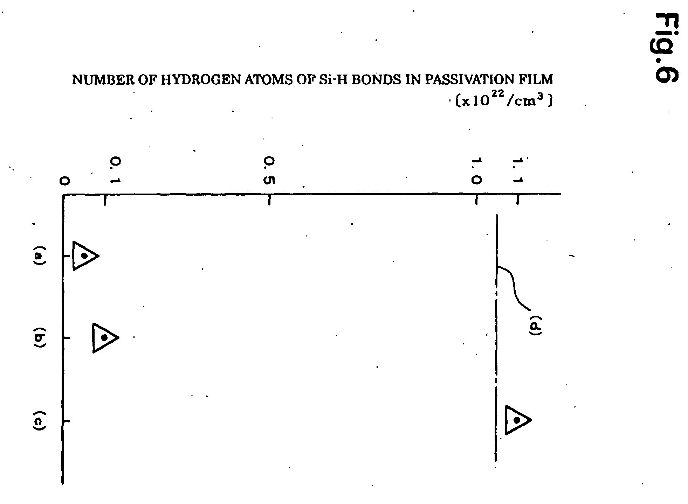

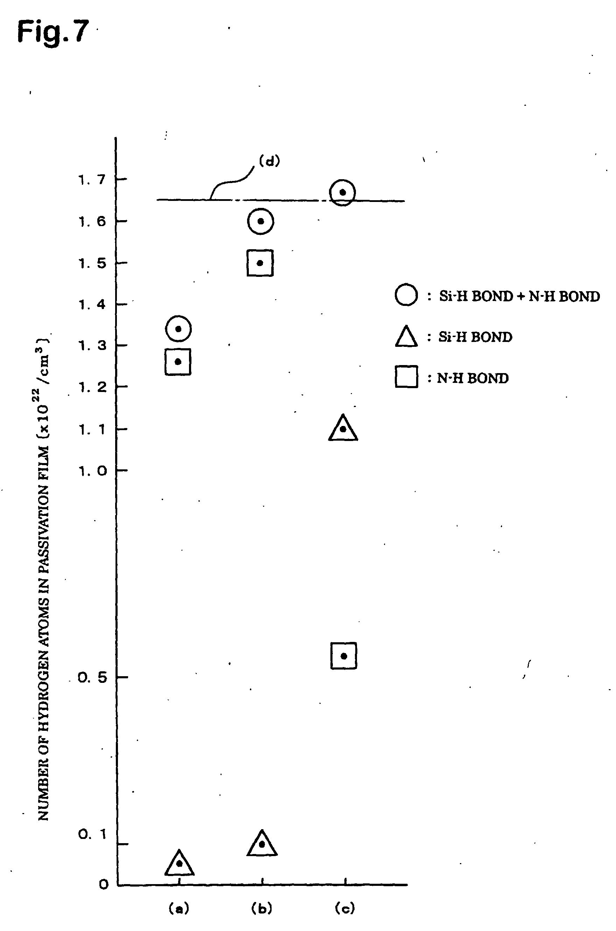

In this embodiment, the volume percentage of $SiH_4$ and $NH_3$ which are gases containing hydrogen in the film forming gaseous components is set at about 6 % ($SiH_4$: about 1 %, $NH_3$: about 5 %) (see Fig. 5, (a)). The concentration of the hydrogen constituting the Si-H bonds in the thus formed passivation film 42 (silicon nitride film having a low hydrogen content) was found to be such that the number of the hydrogen atoms was about $0.06 \times 10^{22}/cm^3$. (see Fig. 6, (a)). Further, the total concentration of the hydrogen constituting the Si-H bonds and N-H bonds of the passivation film 42 was such that the number of the hydrogen atoms was about $1.3 \times 10^{22}/cm^3$ (see Fig. 7, (a)). The hydrogen concentrations of Si-H bonds and N-H bonds in the passivation film 42 were measured with a measuring apparatus (QS-300 manufactured by BIO-RAD Inc.) using FTIR (Fourier transform infrared spectrum) method.

Influence of the film forming process for the passivation film 42 and of the thus obtained passivation film 42 upon the ferroelectric layer 34 of the ferroelectric capacitor Cf was investigated by experiments. In the experiments, switching capacity $Q_{SW}$ (described hereinafter) of the ferroelectric capacitor Cf was measured before and after the formation of the passivation film 42 to calculate a difference of the switching capacity $Q_{SW}$ after the formation of the passivation film 42 as compared with the switching capacity $Q_{SW}$ before the formation of the passivation film 42.

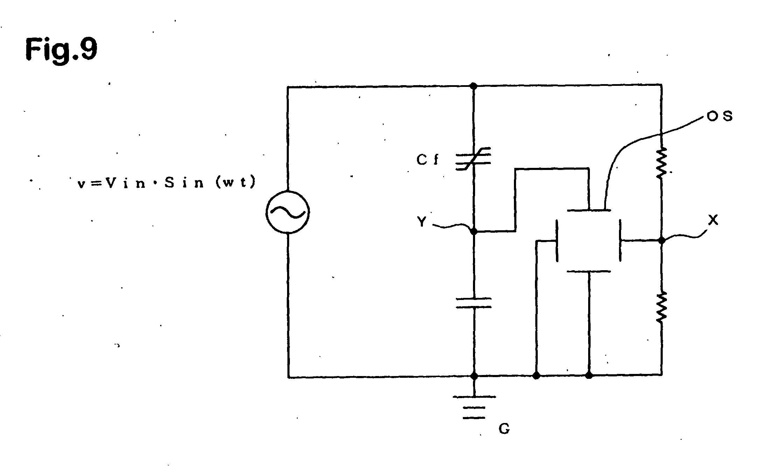

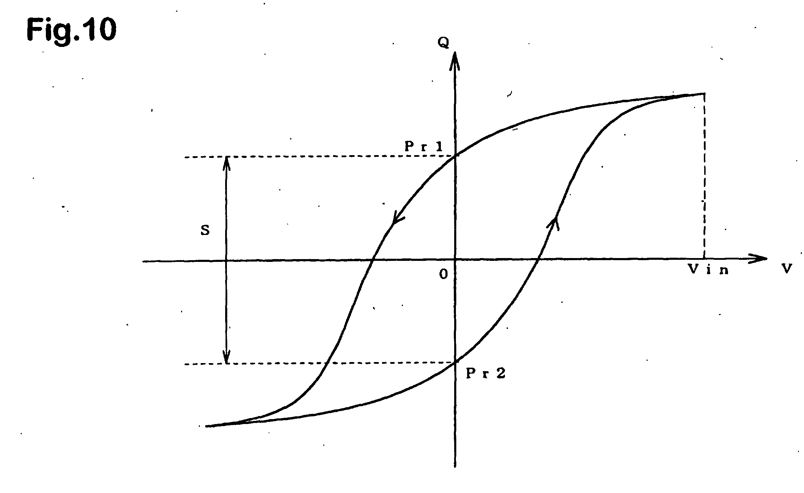

The switching capacity $Q_{SW}$ was measured using an ordinary Sawyer-Tower circuit as shown in Fig. 9. The Sawyer-Tower circuit is applied with an alternate voltage $v = Vin \cdot \sin(\omega t)$. By measuring the electric potential at the points X and Y of the Sawyer-Tower circuit, it is possible to determine the relationship between the alternate voltage v impressed to the ferroelectric capacitor Cf and the polarization charge Q of the ferroelectric capacitor Cf. Fig. 10 illustrates the above relationship indicated on an oscilloscope of the Sawyer-Tower circuit.

In Fig. 10, designated as Pr1 and Pr2 are two residual polarization charges of the ferroelectric capacitor Cf corresponding to the voltage impressing hysteresis thereof at the impression voltage v of zero. The switching capacity $Q_{SW}$ is a sum S of the absolute values of the residual polarization charges Pr1 and Pr2. Thus, the greater the switching capacity $Q_{SW}$, the better is the ability of the memory cell. Accordingly, the smaller a reduction of the switching capacity $Q_{SW}$ of the ferroelectric capacitor Cf after the formation of the passivation film 42, the smaller is a decrease of the ability of the memory cell.

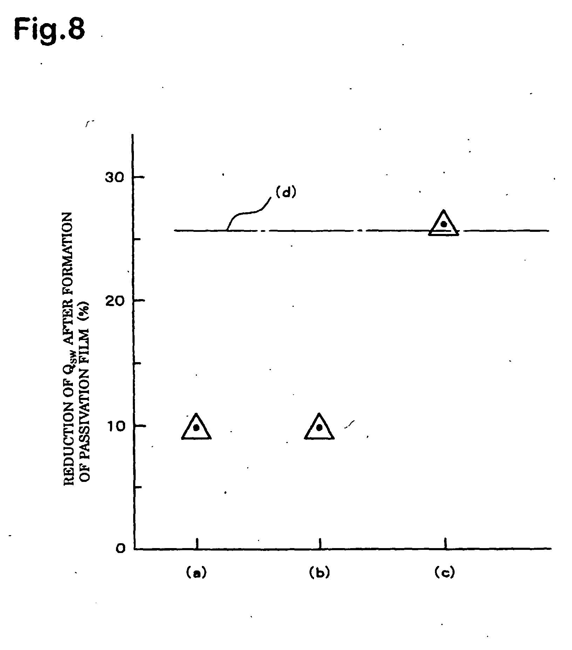

In the present embodiment, the reduction in the switching capacity $Q_{SW}$ of the ferroelectric capacitor Cf after the formation of the passivation film 42 was less than 10 % as shown in Fig. 8(a). Such a reduction of the switching capacity $Q_{SW}$ is not considered to cause problems in practical application.

In the above-described embodiment, the silicon nitride film was formed while controlling the amount of $SiH_4$ and $NH_3$, being a hydrogen-containing gas contained in the film forming gas for the passivation film 42, to about 6 % by volume (see Fig. 5, (a)). Described next will be an example in which a silicon nitride oxide film was formed while controlling the amount of $SiH_4$ and $NH_3$ contained in the film forming gas for the passivation film 42, to about 25 % by volume (see Fig. 5, (b)).

The concentration of the hydrogen constituting the Si-H bonds in the thus formed passivation film 42 (silicon nitride oxide film) was found to be such that the number of the hydrogen atoms was about $0.1 \times 10^{22}/cm^3$ (see Fig. 6, (b)). Further, the total concentration of the hydrogen constituting the Si-H bonds and N-H bonds of the passivation film 42 was such that the number of the hydrogen atoms was about $1.6 \times 10^{22}/cm^3$ (see Fig. 7, (b)). In this case, too, the reduction in the switching capacity $Q_{SW}$ of the ferroelectric capacitor Cf after the formation of the passivation film 42 was less than 10 % as shown in Fig. 8(b).

Described further will be an example in which a silicon nitride film having an ordinary hydrogen concentration was formed while controlling the amount of $SiH_4$ and $NH_3$ contained in the film forming gas for the passivation film 42, to about 75 % by volume (see Fig. 5, (c)).

The concentration of the hydrogen constituting the Si-H bonds in the thus formed passivation film 42 (silicon nitride film) was found to be such that the number of the hydrogen atoms was about $1.1 \times 10^{22}/cm^3$ (see Fig. 6, (c)). Further, the total concentration of the hydrogen constituting the Si-H bonds and N-H bonds of the passivation film 42 was such that the number of the hydrogen atoms was about $1.7 \times 10^{22}/cm^3$ (see Fig. 7, (c)). In this case, the reduction in the switching capacity $Q_{SW}$ of the ferroelectric capacitor Cf after the formation of the passivation film 42 was about 27 % as shown in Fig. 8(c). Such a redubtion of the switching capacity $Q_{SW}$ is not considered to cause problems in practical application.

The volume % of $SiH_4$ and $NH_3$, being a hydrogen-containing gas contained in the film forming gas for the passivation film 42, is not specifically limited, but is preferably less than about 70 % (see Fig. 5, (d)). By controlling the volume % of $SiH_4$ and $NH_3$ to less than about 70 %, the rate of reduction of the switching capacity $Q_{SW}$ of the ferroelectric capacitor Cf can be suppressed to below 25 % (see Fig. 8, (d)). By suppressing the reduction of the switching capacity $Q_{SW}$ of the ferroelectric capacitor Cf below about 25 %, the reliability of the ferroelectric memory M is further improved.

By controlling the volume % of $SiH_4$ and $NH_3$ contained in the film forming gas for the passivation film 42 to about 70 % or less, the concentration of the hydrogen constituting the Si-H bonds in the passivation film 42 is considered to be such that the number of the hydrogen atoms is about $1.0 \times 10^{22}/cm^3$ or less (see Fig. 6, (d)). Further, by controlling the volume % of $SiH_4$ and $NH_3$ contained in the film forming gas for the passivation film 42 to about 70 % or less, the total concentration of the hydrogen constituting the Si-H bonds and N-H bonds of the passivation film 42 is considered to be such that the number of the hydrogen atoms is about $1.6 \times 10^{22}/cm^3$ or less (see Fig. 7, (d)).

It is more preferred that the volume % of $SiH_4$ and $NH_3$ contained in the film forming gas for the passivation film 42 be about 30 % or less (see Fig. 5), since the reduction rate of $Q_{SW}$ is less than about 10 % (see Fig. 8).

By controlling the volume % of $SiH_4$ and $NH_3$ contained in the film forming gas for the passivation film 42 to about 30 % or less, the concentration of the hydrogen constituting the Si-H bonds in the passivation film 42 is considered to be such that the number of the hydrogen atoms is about $0.1 \times 10^{22}/cm^3$ or less (see Fig. 6). Further, by controlling the volume % of $SiH_4$ and $NH_3$ contained in the film forming gas for the passivation film 42 to about 30 % or less, the total concentration of the hydrogen constituting the Si-H bonds and N-H bonds of the passivation film 42 is considered to be such that the number of the hydrogen atoms is about $1.6 \times 10^{22}/cm^3$ or less (see Fig. 7).

It is also preferred that the volume % of $SiH_4$ and $NH_3$ contained in the film forming gas for the passivation film 42 be about 6 % or less (see Fig. 5), since the reduction rate of $Q_{SW}$ is less than about 10 % (see Fig. 8).

By controlling the volume % of $SiH_4$ and $NH_3$ contained in the film forming gas for the passivation film 42 to about 6 % or less, the concentration of the hydrogen constituting the Si-H bonds in the passivation film 42 is considered to be such that the number of the hydrogen atoms is about $0.06 \times 10^{22}/cm^3$ or less (see Fig. 6). Further, by controlling the volume % of $SiH_4$ and $NH_3$ contained in the film forming gas for the passivation film 42 to about 6 % or less, the total concentration of the hydrogen constituting the Si-H bonds and N-H bonds of the passivation film 42 is considered to be such that the number of the hydrogen atoms is about $1.3 \times 10^{22}/cm^3$ or less (see Fig. 7).

The fact that the rate of reduction in $Q_{SW}$ can be suppressed by controlling the volume % of $SiH_4$ and $NH_3$, being a hydrogen-containing gas contained in the film forming gas for the passivation film 42, to a low level is considered to be ascribed to the smallness of hydrogen generation during the film forming process and, hence, to prevention of deterioration of the ferroelectric capacitor Cf due hydrogen.

Similarly, the fact that the rate of reduction in $Q_{SW}$ can be suppressed to a low level by controlling the concentration of the hydrogen in the Si-H bonds in the passivation film 42 and concentration of the total hydrogen in the Si-H bonds and N-H bonds in the passivation film 42 is considered to be ascribed to the smallness of hydrogen contained in the passivation film 42 and, hence, to prevention of deterioration of the ferroelectric capacitor Cf due hydrogen.

As the upper electrode 36 of the ferroelectric capacitor Cf, an electrode having a two-layered structure in which $IrO_2$ (iridium oxide) and Ir (iridium) are stacked in this order is used, while, as the lower electrode 32, an electrode having a two-layered structure in which $IrO_2$ (iridium oxide) and Pt (platinum) are stacked in this order is used. Thus, by using an oxide, such as $IrO_2$, having electrical conductivity as the electrode, influence by hydrogen upon the ferroelectric layer 34 is considered to be relaxed. In particular, by using a conductive oxide as the upper electrode 36, influence by hydrogen from the passivation film 42 side can be advantageously relaxed.

Such an electrically conductive oxide is not limited to $IrO_2$ only but may be, for example, $RuO_2$, $SrRuO_3$, $PtRhO_x$, SRO+$\alpha$, LSCO (LaSrCo(or Cu)$O_x$ or LSCO+$\alpha$.

The ferroelectric memory M provided with the passivation film 42 constituted of the thus prepared silicon nitride film (see Figs. 5-8, (a)) having, a low hydrogen concentration, the ferroelectric memory M provided with the passivation film 42 constituted of the silicon nitride oxide film (see Figs. 5-8, (b)) and the ferroelectric memory M provided with the passivation film 42 constituted of the silicon nitride film (see Figs. 5-8, (c)) having ordinary hydrogen concentration were prepared, each 30 pieces, and subjected to HAST (unsaturated vapor pressurizing test, EIAJ ED-4701). The test was carried out by allowing the sample at a temperature of 150°C and a relative humidity of 80 % for 300 hours while applying a voltage thereto.

The test results were such that, among the ferroelectric memory M provided with the passivation film 42 constituted of the silicon nitride film having a low hydrogen concentration, the ferroelectric memory M provided with the passivation film 42 constituted of the silicon nitride oxide film and the ferroelectric memory M provided with the passivation film 42 constituted of the silicon nitride film having ordinary hydrogen concentration, there were no samples whose device characteristics were deteriorated. When the similar test was carried out for the ferroelectric memory provided with the passivation film 42 constituted of the conventional silicon oxide film, there were samples whose device characteristics were deteriorated.

The above results are considered to suggest that when the passivation film 42 is constituted of a dense silicon nitride-containing material, such as a silicon nitride film having a low hydrogen concentration, a silicon nitride oxide film or a silicon nitride film having an ordinary hydrogen concentration, the moisture-proofing property of the passivation film 42 is improved. Namely, the passivation film 42 is considered to be able to prevent intrusion of moisture from outside of the ferroelectric memory M.

The above embodiments have been described with respect to an example in which the conductive layer is an upper conductive layer (upper electrode). The present invention, however, can be applied to a case in which the conductive layer is a lower conductive layer (lower electrode).

While the above embodiments have been described with respect to an example in which the conductive layer has a two-layered structure, the present invention is not limited thereto. For example, the present invention can be applied to a case in which the conductive layer has a single layer structure or a three-layered structure.

While the above embodiments use a plasma CVD method as a method of forming the passivation film 42, the method of forming the passivation film 42 is not limited thereto. The passivation film 42 may be formed by, for example, an ambient pressure CVD method.

Further, while the above embodiments have been described with respect to an example in which the insulation layer is a surface protecting film (passivation film) covering the ferroelectric layer indirectly, the present invention can be applied to a case in which the insulation layer is a surface protecting film directly covering the ferroelectric layer. Moreover, while the above description has been made with respect to an example in which the insulation layer is a surface protecting film, the present invention is not limited thereto. The present invention is applicable to a case in which the insulation layer is an interlayer film.

Further, while the above description has been made with respect to an example in which PZT is used as a ferroelectric material, the present invention is not limited thereto. The present invention is applicable to a case in which the ferroelectric material is, for example, Y1 or SBT.

Further, while the above description has been made with respect to an example in which the ferroelectric memory having a 2-transistor/2-capacitor structure is used as a semiconductor device, the present invention is not limited thereto. The present invention is applicable to a ferroelectric memory having a 1-transistor/1-capacitor structure. The present invention is also applicable to a ferroelectric memory of an FFT-type, such as FFT (electric field effect transistor) having an MFMIS (Metal Ferroelectric Metal Insulator Silicon) structure. The present invention is applied not only to a ferroelectric memory but also to a semiconductor device in general that utilizes a ferroelectric material.

The semiconductor device according to the present invention is characterized in that the insulation layer is formed of an insulating material comprising silicon nitride, and in that the conductive layer is formed of an electrically conductive material comprising a conductive oxide.

By constituting the insulation layer using an insulating material comprising silicon nitride, the insulation layer has an improved moisture-proofing property. Further, by constituting the conductive layer using an electrically conductive material comprising an oxide, influence by hydrogen upon the ferroelectric layer is considered to be relaxed. Therefore, a reduction of the switching capacity of the ferroelectric layer by the formation of the insulation layer can be suppressed in a certain degree. Namely, it is possible to realize a semiconductor device in which hysteresis characteristic of the ferroelectric material is not easily deteriorated and which has high reliability under high humidity conditions.

The semiconductor device according to the present invention is characterized in that the conductive layer comprises a first layer formed of iridium oxide and a second layer in contact with the first layer and formed of iridium. Thus, it is possible to select the materials of the first and second layers while taking into consideration the adhesion thereof to each layer in contact with the conductive layer.

The semiconductor device according to the present invention is characterized in that the insulation layer is formed of silicon nitride. Thus, it is possible to realize a denser insulation layer and, hence, it is possible to realize a semiconductor device having better reliability under high humidity conditions.

The semiconductor device according to the present invention is characterized in that the insulation layer is formed of silicon nitride oxide. Thus, it is possible to realize an insulation layer in which stresses occurring therein are small. Further, the production efficiency can be improved. Therefore, it is possible to provide an inexpensive semiconductor device having high reliability.

The semiconductor device according to the present invention is characterized in that the insulation layer is a surface protecting film directly or indirectly covering the ferroelectric layer. Thus, it is possible to minimize the intrusion of moisture from surfaces of the semiconductor device.

The semiconductor device according to the present invention is characterized in that the device comprises a surface protecting film indirectly covering the ferroelectric layer, and in that the insulation layer is an interlayer film provided inside the surface protecting layer and directly or indirectly covering the ferroelectric layer. Thus, it is possible to minimize the moisture contained in the insulation layer itself confined inside the surface protecting layer. Therefore, it is possible to realize a semiconductor device having further improved reliability against humid conditions.

The semiconductor device according to the present invention is characterized in that the device comprises a ferroelectric capacitor including a lower conductive layer, the ferroelectric layer and an upper conductive layer stacked in this order. Thus, it is possible to realize a memory cell which has a simple construction, in which hysteresis characteristic of the ferroelectric material is not easily deteriorated and which has high reliability under high humidity conditions.

The process of fabricating a semiconductor device is characterized in that a ferroelectric layer is formed using a ferroelectric material, in that an electrically conductive layer is formed using an electrically conductive material comprising a conductive oxide, and in that an insulation layer formed of an insulating material comprising silicon nitride is thereafter formed using a film forming gas containing silane and ammonia.

Thus, by forming the insulation layer using an insulating material comprising silicon nitride, the moisture-proofing property of the insulation layer can be improved. Further, by forming the conductive layer using an electrically conductive material comprising a conductive oxide, it is possible to suppress in a certain degree a reduction of the switching capacity of the ferroelectric layer by the formation of the insulation layer. Namely, it is possible to fabricate a semiconductor device in which hysteresis characteristic of the ferroelectric material is not easily deteriorated and which has high reliability under high humidity conditions.

The semiconductor device according to the present invention is characterized in that an insulation layer is formed of an insulation material containing silicon nitride having silicon-hydrogen bonds, and in that the concentration of the hydrogen constituting the silicon-hydrogen bonds is such that the number of the hydrogen atoms is substantially not greater than $1.0 \times 10^{22}/cm^3$.

Thus, by constituting the insulation layer using an insulation material containing silicon nitride, the moisture-proofing property of the insulation layer can be improved. Further, by controlling the concentration of the hydrogen constituting the silicon-hydrogen bonds such that the number of the hydrogen atoms is substantially not greater than $1.0 \times 10^{22}/cm^3$, it is possible to suppress a reduction of the switching capacity of the ferroelectric layer by the formation of the insulation layer within an allowable range. Namely, it is possible to realize a semiconductor device in which hysteresis characteristic of the ferroelectric material is not easily deteriorated and which has high reliability under high humidity conditions.

The semiconductor device according to the present invention is characterized in that the insulation layer is formed of an insulation material containing silicon nitride having silicon-hydrogen bonds and nitrogen-hydrogen bonds, and in that the concentration of the hydrogen constituting the silicon-hydrogen bonds and nitrogen-hydrogen bonds is such that the number of the hydrogen atoms is substantially not greater than $1.6 \times 10^{22}/cm^3$.

Thus, by constituting the insulation layer using an insulation material containing silicon nitride, the moisture-proofing property of the insulation layer can be improved. Further, by controlling the concentration of the hydrogen constituting the silicon-hydrogen bonds and nitrogen-hydrogen bonds such that the number of the hydrogen atoms is substantially not greater than $1.6 \times 10^{22}/cm^3$, it is possible to suppress a reduction of the switching capacity of the ferroelectric layer by the formation of the insulation layer within an allowable range. Namely, it is possible to realize a semiconductor device in which hysteresis characteristic of the ferroelectric material is not easily deteriorated and which has high reliability under high humidity conditions.

The semiconductor device according to the present invention is characterized in that the insulation layer is formed of an insulation material containing silicon nitride, and in that the concentration of hydrogen contained in the insulation layer is so adjusted that a switching capacitance of the ferroelectric layer after the insulation layer has been formed is reduced by no more than 25 % of a switching capacitance of the ferroelectric layer before the formation of the insulation layer.

Thus, by constituting the insulation layer using an insulation material containing silicon nitride, the moisture-proofing property of the insulation layer can be improved. Further, by adjusting the concentration of hydrogen contained in the insulation layer such that a switching capacitance of the ferroelectric layer after the insulation layer has been formed is reduced by no more than 25 % of a switching capacitance of the ferroelectric layer before the formation of the insulation layer, it is possible to suppress a reduction of the switching capacity of the ferroelectric layer by the formation of the insulation layer within an allowable range. Namely, it is possible to realize a semiconductor device in which hysteresis characteristic of the ferroelectric material is not easily deteriorated and which has high reliability under high humidity conditions.

The semiconductor device according to the present invention is characterized in that the insulation layer is formed of a silicon nitride film. Thus, it is possible to realize a denser insulation layer and, hence, it is possible to realize a semiconductor device having higher reliability under high humidity conditions.

The semiconductor device according to the present invention is characterized in that the insulation layer is formed of a silicon nitride oxide film. Thus, it is possible to realize an insulation layer in which stresses occurring therein are small. Further, the production efficiency can be improved. Therefore, it is possible to provide an inexpensive semiconductor device having high reliability.

The semiconductor device according to the present invention is characterized in that the device comprises an electrically conductive layer in contact with the ferroelectric layer, and in that the conductive layer is formed of an electrically conductive material comprising a conductive oxide. Thus, by constituting the conductive layer using an electrically conductive material comprising a conductive oxide, influence by hydrogen upon the ferroelectric layer is considered to be relaxed. Therefore, the hysteresis characteristic of the ferroelectric material is hardly deteriorated.

The semiconductor device according to the present invention is characterized in that the conductive layer comprises a first layer formed of iridium oxide and a second layer in contact with the first layer and formed of iridium. Thus, it is possible to select the materials of the first and second layers while taking into consideration the adhesion thereof to each layer in contact with the conductive layer.

The semiconductor device according to the present invention is characterized in that the insulation layer is a surface protecting film directly or indirectly covering the ferroelectric layer. Thus, it is possible to minimize the intrusion of moisture from surfaces of the semiconductor device.

The semiconductor device according to the present invention is characterized in that the device comprises a surface protecting film indirectly covering the ferroelectric layer, and in that the insulation layer is an interlayer film provided inside the surface protecting layer and directly or indirectly covering the ferroelectric layer. Thus, it is possible to minimize the moisture contained in the insulation layer itself confined inside the surface protecting layer. Therefore, it is possible to realize a semiconductor device having further improved reliability against humid conditions.

The semiconductor device according to the present invention is characterized in that the device comprises a ferroelectric capacitor including a lower conductive layer, the ferroelectric layer and an upper conductive layer stacked in this order. Thus, it is possible to realize a memory cell which has a simple construction, in which hysteresis characteristic of the ferroelectric material is not easily deteriorated and which has high reliability under high humidity conditions.

The process of fabricating a semiconductor device according to the present invention is characterized in that, after the formation of the ferroelectric capacitor, the insulation layer is formed using a film forming gas containing silane and ammonia such that the insulation layer is formed of an insulating material comprising silicon nitride, and in that a volume of the silane and ammonia in the film forming gas is substantially not greater than 70 %.

Thus, by forming the insulation layer using an insulating material comprising silicon nitride, the moisture-proofing property of the insulation layer can be improved. Further, by controlling a volume of the silane and ammonia in the film forming gas to substantially not greater than 70 %, it is possible to suppress a reduction of the switching capacity of the ferroelectric layer by the formation of the insulation layer within an allowable range. Namely, it is possible to fabricate a semiconductor device in which hysteresis characteristic of the ferroelectric material is not easily deteriorated and which has high reliability under high humidity conditions.

The present invention has been described in the foregoing with regard to the preferred embodiments thereof, in which respective terms have been used as illustrative and not restrictive and may be changed without departing from the scope or spirit of the present invention within the scope of the appended claims.

## Claims

1. A semiconductor device comprising a ferroelectric layer, an electrically conductive layer in contact with said ferroelectric layer and an insulation layer disposed near said ferroelectric layer, characterized

    in that said insulation layer is formed of an insulating material comprising silicon nitride, and
    in that said conductive layer is formed of an electrically conductive material comprising a conductive oxide.

2. A semiconductor device according to claim 1, characterized in that said conductive oxide is iridium oxide.

3. A semiconductor device according to claim 2, characterized in that said conductive layer comprises a first layer formed of iridium oxide and a second layer in contact with said first layer and formed of iridium.

4. A semiconductor device according to claim 1, characterized in that said insulation layer is formed of silicon nitride.

5. A semiconductor device according to claim 1, characterized in that said insulation layer is formed of silicon nitride oxide.

6. A semiconductor device according to claim 1, characterized in that said insulation layer is a surface protecting film directly or indirectly covering said ferroelectric layer.

7. A semiconductor device according to claim 1, characterized

    in that said device comprises a surface protecting film indirectly covering said ferroelectric layer, and
    in that said insulation layer is an interlayer film provided inside said surface protecting layer and directly or indirectly covering said ferroelectric layer.

8. A semiconductor device according to claim 1, characterized

    in that said device comprises a ferroelectric capacitor including a lower conductive layer, said ferroelectric layer and an upper conductive layer stacked in this order,
    in that at least one of said lower and upper conductive layer is said electrically conductive layer, and
    in that said insulation layer is a film directly or indirectly covering said ferroelectric capacitor.

9. A semiconductor device according to claim 8, characterized

    in that said upper conductive layer is said electrically conductive layer, and
    in that said insulation layer is a surface protecting layer covering said ferroelectric capacitor.

10. A semiconductor device according to claim 8, characterized

    in that said device comprises a surface protecting film indirectly covering said ferroelectric capacitor, and
    in that said insulation layer is an interlayer film provided inside said surface protecting layer and covering said ferroelectric capacitor.

11. A process of fabricating a semiconductor device comprising a ferroelectric layer, an electrically conductive layer in contact with said ferroelectric layer and an insulation layer disposed near said ferroelectric layer, characterized

    in that said ferroelectric layer is formed using a ferroelectric material and said electrically conductive layer is formed using an electrically conductive material comprising a conductive oxide, and
    in that said insulation layer is thereafter formed using a film forming gas containing silane and ammonia and is formed of an insulating material comprising silicon nitride.

12. A process of fabricating a semiconductor device according to claim 11,
    wherein said device comprises a ferroelectric capacitor including a lower conductive layer, said ferroelectric layer and an upper conductive layer stacked in this order,
    wherein at least one of said lower and upper conductive layer is said electrically conductive layer, and
    wherein said insulation layer is a film directly or indirectly covering said ferroelectric capacitor,

    said process being characterized in that, after the formation of said ferroelectric capacitor, said insulation layer is formed using a film forming gas containing silane and ammonia.

**13.** A semiconductor device comprising a ferroelectric layer and an insulation layer disposed near said ferroelectric layer, characterized

in that said insulation layer is formed of an insulation material containing silicon nitride having silicon-hydrogen bonds, and
in that the concentration of the hydrogen constituting said silicon-hydrogen bonds is such that the number of the hydrogen atoms is substantially not greater than $1.0 \times 10^{22}/cm^3$.

**14.** A semiconductor, device comprising a ferroelectric layer and an insulation layer disposed near said ferroelectric layer, characterized

in that said insulation layer is formed of an insulation material containing silicon nitride having silicon-hydrogen bonds and nitrogen-hydrogen bonds, and
in that the concentration of the hydrogen constituting said silicon-hydrogen bonds and nitrogen-hydrogen bonds is such that the number of the hydrogen atoms is substantially not greater than $1.6 \times 10^{22}/cm^3$.

**15.** A semiconductor device comprising a ferroelectric layer and an insulation layer disposed near said ferroelectric layer, characterized

in that said insulation layer is formed of an insulation material containing silicon nitride, and
in that the concentration of hydrogen contained in said insulation layer is so adjusted that a switching capacitance of said ferroelectric layer after said insulation layer has been formed is reduced by no more than 25 % of a switching capacitance of said ferroelectric layer before the formation of said insulation layer.

**16.** A semiconductor device according to claim 13, characterized in that said insulation layer is formed of a silicon nitride film.

**17.** A semiconductor device according to claim 14, characterized in that said insulation layer is formed of a silicon nitride film.

**18.** A semiconductor device according to claim 15, characterized in that said insulation layer is formed of a silicon nitride film.

**19.** A semiconductor device according to claim 13, characterized in that said insulation layer is formed of a silicon nitride oxide film.

**20.** A semiconductor device according to claim 14, characterized in that said insulation layer is formed of a silicon nitride oxide film.

**21.** A semiconductor device according to claim 15, characterized in that said insulation layer is formed of a silicon nitride oxide film.

**22.** A semiconductor device according to claim 13, characterized

in that said device comprises an electrically conductive layer in contact with said ferroelectric layer, and
in that said conductive layer is formed of an electrically conductive material comprising a conductive oxide.

**23.** A semiconductor device according to claim 14, characterized

in that said device comprises an electrically conductive layer in contact with said ferroelectric layer, and
in that said conductive layer is formed of an electrically conductive material comprising a conductive oxide.

**24.** A semiconductor device according to claim 15, characterized

in that said device comprises an electrically conductive layer in contact with said ferroelectric layer, and
in that said conductive layer is formed of an electrically conductive material comprising a conductive oxide.

**25.** A semiconductor device according to claim 22, characterized in that said conductive oxide is iridium oxide.

**26.** A semiconductor device according to claim 23, characterized in that said conductive oxide is iridium oxide.

**27.** A semiconductor device according to claim 24, characterized in that said conductive oxide is iridium oxide.

**28.** A semiconductor device according to claim 25, characterized in that said conductive layer comprises a first layer formed of iridium oxide and a second layer in contact with said first layer and formed of iridium.

**29.** A semiconductor device according to claim 26, characterized in that said conductive layer comprises a first layer formed of iridium oxide and a second layer in contact with said first layer and formed of iridium.

30. A semiconductor device according to claim 27, characterized in that said conductive layer comprises a first layer formed of iridium oxide and a second layer in contact with said first layer and formed of iridium.

31. A semiconductor device according to claim 13, characterized in that said insulation layer is a surface protecting film directly or indirectly covering said ferroelectric layer.

32. A semiconductor device according to claim 14, characterized in that said insulation layer is a surface protecting film directly or indirectly covering said ferroelectric layer.

33. A semiconductor device according to claim 15, characterized in that said insulation layer is a surface protecting film directly or indirectly covering said ferroelectric layer.

34. A semiconductor device according to claim 13, characterized

in that said device comprises a surface protecting film indirectly covering said ferroelectric layer, and
in that said insulation layer is an interlayer film provided inside said surface protecting layer and directly or indirectly covering said ferroelectric layer.

35. A semiconductor device according to claim 14, characterized

in that said device comprises a surface protecting film indirectly covering said ferroelectric layer, and
in that said insulation layer is an interlayer film provided inside said surface protecting layer and directly or indirectly covering said ferroelectric layer.

36. A semiconductor device according to claim 15, characterized

in that said device comprises a surface protecting film indirectly covering said ferroelectric layer, and
in that said insulation layer is an interlayer film provided inside said surface protecting layer and directly or indirectly covering said ferroelectric layer.

37. A semiconductor device according to claim 22, characterized

in that said device comprises a ferroelectric capacitor including a lower conductive layer, said ferroelectric layer and an upper conductive layer stacked in this order,
in that at least one of said lower and upper conductive layer is said electrically conductive layer, and
in that said insulation layer is a film directly or indirectly covering said ferroelectric capacitor.

38. A semiconductor device according to claim 23, characterized

in that said device comprises a ferroelectric capacitor including a lower conductive layer, said ferroelectric layer and an upper conductive layer stacked in this order,
in that at least one of said lower and upper conductive layer is said electrically conductive layer, and
in that said insulation layer is a film directly or indirectly covering said ferroelectric capacitor.

39. A semiconductor device according to claim 24, characterized

in that said device comprises a ferroelectric capacitor including a lower conductive layer, said ferroelectric layer and an upper conductive layer stacked in this order,
in that at least one of said lower and upper conductive layer is said electrically conductive layer, and
in that said insulation layer is a film directly or indirectly covering said ferroelectric capacitor.

40. A semiconductor device according to claim 37, characterized

in that said upper conductive layer is said electrically conductive layer, and
in that said insulation layer is a surface protecting layer covering said ferroelectric capacitor.

41. A semiconductor device according to claim 38, characterized

in that said upper conductive layer is said electrically conductive layer, and
in that said insulation layer is a surface protecting layer covering said ferroelectric capacitor.

42. A semiconductor device according to claim 39, characterized

in that said upper conductive layer is said electrically conductive layer, and

in that said insulation layer is a surface protecting layer covering said ferroelectric capacitor.

43. A semiconductor device according to claim 37, characterized

in that said device comprises a surface protecting film indirectly covering said ferroelectric capacitor, and
in that said insulation layer is an interlayer film provided inside said surface protecting layer and covering said ferroelectric capacitor.

44. A semiconductor device according to claim 38, characterized

in that said device comprises a surface protecting film indirectly covering said ferroelectric capacitor, and
in that said insulation layer is an interlayer film provided inside said surface protecting layer and covering said ferroelectric capacitor.

45. A semiconductor device according to claim 39, characterized

in that said device comprises a surface protecting film indirectly covering said ferroelectric capacitor, and
in that said insulation layer is an interlayer film provided inside said surface protecting layer and covering said ferroelectric capacitor.

46. A process of fabricating a semiconductor device comprising a ferroelectric layer, and an insulation layer disposed near said ferroelectric layer, characterized

in that, after the formation of said ferroelectric capacitor, said insulation layer is formed using a film forming gas containing silane and ammonia such that said insulation layer is formed of an insulating material comprising silicon nitride, and
in that a volume of said silane and ammonia in said film forming gas is substantially not greater than 70 %.

47. A process of fabricating a semiconductor device according to claim 46,
wherein said device comprises a ferroelectric capacitor including a lower conductive layer, said ferroelectric layer and an upper conductive layer stacked in this order, and
wherein said insulation layer is a film directly or indirectly covering said ferroelectric capacitor,

said process being characterized in that, after the formation of said ferroelectric capacitor, said insulation layer is formed using a film forming gas containing silane and ammonia.

EP 1 035 587 A1

# Fig.1

38 : INTERLAYER FILM
40 : ALUMINUM WIRE
42 : PASSIVATION FILM
Cf : FERROELECTRIC CAPACITOR

# Fig.2A

24

22

# Fig.2B

28

26

24

22

# Fig.3A

28

30

26

# Fig.3B

Cf {
36
34
32
}

30

## Fig.4A

## Fig.4B

# Fig.5

# Fig.6

# Fig.7

NUMBER OF HYDROGEN ATOMS IN PASSIVATION FILM ($\times 10^{22}/cm^3$)

○ : Si-H BOND + N-H BOND

△ : Si-H BOND

□ : N-H BOND

# Fig.8

# Fig.9

Fig.10

# Fig.11

# Fig.12

EP 1 035 587 A1

# INTERNATIONAL SEARCH REPORT

| International application No. |
|---|
| PCT/JP98/03724 |

| A. CLASSIFICATION OF SUBJECT MATTER |
|---|
| Int.Cl⁶ H01L27/10, H01L21/8239, H01L21/318, H01L21/822, H01L27/04 |

According to International Patent Classification (IPC) or to both national classification and IPC

| B. FIELDS SEARCHED |
|---|
| Minimum documentation searched (classification system followed by classification symbols) |
| Int.Cl⁶ H01L27/10, H01L21/8239, H01L21/318, H01L21/822, H01L27/04 |

Documentation searched other than minimum documentation to the extent that such documents are included in the fields searched

| Jitsuyo Shinan Koho | 1926-1998 | Toroku Jitsuyo Shinan Koho | 1994-1998 |
|---|---|---|---|
| Kokai Jitsuyo Shinan Koho | 1971-1996 | Jitsuyo Shinan Toroku Koho | 1996-1998 |

Electronic data base consulted during the international search (name of data base and, where practicable, search terms used)

## C. DOCUMENTS CONSIDERED TO BE RELEVANT

| Category* | Citation of document, with indication, where appropriate, of the relevant passages | Relevant to claim No. |
|---|---|---|
| X | JP, 9-97883, A (Sony Corp.),<br>8 April, 1997 (08. 04. 97),<br>Column 5, line 30 to column 9, line 21<br>& EP, 766319, A | 1, 2, 4-10 |
| Y | | 3 |
| X | JP, 8-37282, A (Matsushita Electronics Corp.),<br>6 February, 1996 (06. 02. 96),<br>Column 5, line 10 to column 7, line 20<br>(Family: none) | 13-21, 31-36 |
| Y | | 1-12, 22-30, 37-45 |
| Y | JP, 9-148535, A (Sanyo Electric Co., Ltd.),<br>6 June, 1997 (06. 06. 97),<br>Column 3, line 5 to column 7, line 29 (Family: none) | 1-12, 22-30, 37-45 |
| Y | JP, 6-334050, A (Mitsubishi Electric Corp.),<br>2 December, 1994 (02. 12. 94),<br>Column 4, line 27 to column 5, line 37<br>(Family: none) | 11, 12 |

| [x] Further documents are listed in the continuation of Box C. | [ ] See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | |
| "O" document referring to an oral disclosure, use, exhibition or other means | "Y" document of particular relevance; the claimed invention cannot be considered to involve an inventive step when the document is combined with one or more other such documents, such combination being obvious to a person skilled in the art |
| "P" document published prior to the international filing date but later than the priority date claimed | "&" document member of the same patent family |

| Date of the actual completion of the international search | Date of mailing of the international search report |
|---|---|
| 11 November, 1998 (11. 11. 98) | 24 November, 1998 (24. 11. 98) |

| Name and mailing address of the ISA/<br>Japanese Patent Office | Authorized officer |
|---|---|
| Facsimile No. | Telephone No. |

Form PCT/ISA/210 (second sheet) (July 1992)

**EP 1 035 587 A1**

| INTERNATIONAL SEARCH REPORT | International application No. |
|---|---|
| | PCT/JP98/03724 |

C (Continuation).  DOCUMENTS CONSIDERED TO BE RELEVANT

| Category* | Citation of document, with indication, where appropriate, of the relevant passages | Relevant to claim No. |
|---|---|---|
| A | JP, 8-274089, A (Kawasaki Steel Corp.), 18 October, 1996 (18. 10. 96), Column 3, line 27 to column 5, line 13 (Family: none) | 46, 47 |
| A | JP, 59-96736, A (Hitachi, Ltd.), 4 June, 1984 (04. 06. 84), Page 4, lower left column, line 1 to page 4, lower right column, line 16 (Family: none) | 46, 47 |

Form PCT/ISA/210 (continuation of second sheet) (July 1992)

26